# EUROPÄISCHE PATENTSCHRIFT

(11) **EP 1 163 761 B1**
(45) Veröffentlichungstag und Bekanntmachung des Hinweises auf die Patenterteilung: **19.05.2004**
(21) Anmeldenummer: 00918691.7
(22) Anmeldetag: 06.03.2000
(51) Int. Cl.: H04L 12/28

(54) **DIGITALES SIGNALÜBERTRAGUNGSSYSTEM DER GEBÄUDESYSTEMTECHNIK**
DIGITAL SIGNAL TRANSMISSION SYSTEM FOR BUILDING SYSTEMS ENGINEERING
SYSTEME DE TRANSMISSION DE SIGNAUX NUMERIQUE UTILISE DANS LA TECHNIQUE DES SYSTEMES DE BATIMENTS

(30) Priorität: 19.03.1999 DE 19912175
(43) Veröffentlichungstag der Anmeldung: 19.12.2001
(73) Patentinhaber: SIEMENS AKTIENGESELLSCHAFT, 80333 München (DE)
(72) Erfinder: SCHADE, Bernd, D-91052 Erlangen (DE); BITZL, Günter, D-93053 Regensburg (DE); ZEMPELIN, Jens, D-93161 Sinzing (DE)
(86) Internationale Anmeldenummer: PCT/DE2000/000696
(87) Internationale Veröffentlichungsnummer: WO 2000/057603

(56) Entgegenhaltungen:
- EP-A- 0 452 658
- US-A- 5 572 438
- US-A- 5 839 097

## Beschreibung

Die Erfindung bezieht sich auf ein digitales Signalübertragungssystem der Gebäudesystemtechnik gemäß Oberbegriff des Anspruchs 1.

Ein derartiges digitales Signalübertragungssystem ist in der EP-A-0 452 658 beschrieben. Im bekannten Fall weist das digitale Übertragungssystem ein Koppelelement auf, an das Module zur Steuerung von Anwendergeräten über eine Busstruktur anschließbar sind. Sowohl die Energieversorgung als auch die Informationsübertragung zu den Modulen erfolgt hierbei über das Koppelgerät.

Bei einem aus der EP-B-0 365 696 bekannten System werden Anwendergeräte über Busankoppler mit dem Bus verbunden. Ein derartiger Busankoppler weist Bauteile für die physikalische Verbindung zum Bus und für die Übertragung von Informationstelegrammen sowie solche für Kommunikation und für anwenderbezogene Intelligenz auf. Hieran können dann so genannte Anwendergeräte oder Endgeräte angeschlossen werden. Je Anschlussstelle wird hierbei ein Busankoppler mit umfassenden Funktionen bereitgestellt.

Nach einem aus der EP-B-0 344 609 bekannten digitalen Signalübertragungssystem für korrespondierende Endgeräte werden funktionsunabhängige Universal-Schnittstellen verwandt, die zusammen mit dem Bus Bestandteil der Grundinstallation sind. Auf diese Universalschnittstellen werden externe funktionsbestimmende Geräteadapter aufgesetzt, die entsprechend mit umfangreichen Funktionen bereitzustellen sind.

Der Erfindung liegt die Aufgabe zugrunde, ein digitales Signalübertragungssystem der Gebäudesystemtechnik zu entwickeln, das weder auf der Anwenderseite noch busseitig feste oder umfangreiche Funktionen erfordert.

Die Lösung der geschilderten Aufgabe erfolgt durch ein digitales Signalübertragungssystem der Gebäudesystemtechnik nach Anspruch 1.

Hierbei wird das Koppelelement mit einer Anzahl von Festfunktionen für Anwendergeräte, z.B. Schalten, und zugeordneten Anschlussplätzen für Anwendergeräte versehen. Das Koppelelement ist weiter mit einer Anzahl von Anschlussplätzen zum Anschließen von Modulen mit Gattungsfunktionen für Anwendergeräte versehen. Gattungsfunktionen können sein: Aktorfunktionen und/oder Sensorfunktionen und/oder Auswertefunktionen und/oder Telefonfunktionen und/oder Fernsehfunktionen. Die Koppelelemente können auch zum Anschließen von Geräten mit Gattungsfunktionen ausgeführt sein. Ein Koppelelement ist jeweils dafür ausgelegt, Energie für Anwendergeräte bzw. Anwenderfunktionen und Information zu führen und zu verteilen. Die Koppelelemente sind weiter dafür ausgelegt, durch busseitige Informationstelegramme Funktionen in Anwendergeräten und/oder Modulen für Anwendergeräte individuell zu definieren.

Die Koppelelemente sind also mit einer Anzahl von Festfunktionen versehen, um Anwendergeräte anzuschließen, sie haben weiter Anschlussplätze, an denen Module oder auch Geräte direkt angeschlossen werden können. Je Koppelplatz am Bus sind damit nur rudimentäre Funktionen bereitzustellen. Die weiteren Funktionen können individuell durch Anschließen von Modulen bereitgestellt werden, an denen Bedienoberflächen oder Geräteteile angeschlossen werden. An den Anschlussplätzen können Anwendergeräte auch direkt angeschlossen werden.

Nach einer Weiterbildung kann am Koppelelement eingangsseitig für die Energieleitung ein Anschlussplatz für ein Kontrollmodul ausgebildet sein. Das Kontrollmodul kann mit einem Feinschutz für Anwendergeräte versehen sein, es kann auch als Messplatz für Strom und bzw. oder für Spannung ausgeführt sein. Das Kontrollmodul kann auch als Zentrale für Energiemanagement ausgebildet sein. Entsprechend kann man Sicherheitsfunktionen oder Steuerungsfunktionen unter dem Blickwinkel von Energiemanagement zusätzlich bereitstellen.

Das Koppelelement kann hinsichtlich seiner Anschlussplätze durch weitere ansetzbare Ergänzungskoppelelemente erweiterbar sein. Diese Ergänzungskoppelelemente können auf Basisfunktionen des Koppelelements zurückgreifen, an dem sie angeschlossen sind. Sie brauchen hierfür selbst dann nicht ausgelegt zu sein.

Die Erfindung soll nun anhand von in der Zeichnung grob schematisch wiedergegebenen Ausführungsbeispielen weiter erläutert werden:
In FIG 1 ist nach Art einer Explosionsdarstellung ein Koppelelement mit Ergänzungskoppelelementen, einem Kontrollmodul und anschließbaren Modulen für Anwendergeräte wiedergegeben.
In FIG 2 ist eine Anordnung von Koppelelement und Kontrollmodul perspektivisch und bei Durchsicht auf veranschaulichte Leiter dargestellt.

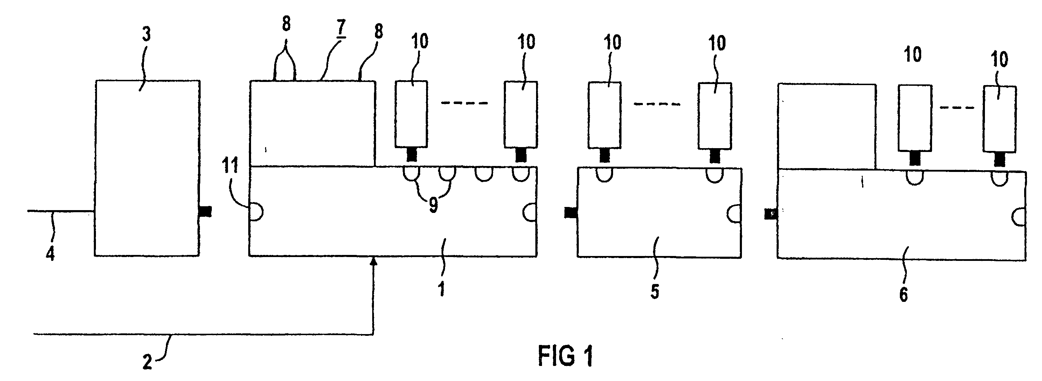

In FIG 1 ist an einem Koppelelement 1 ein Bus 2 angeschlossen. Dem Koppelelement 1 kann energieseitig ein Kontrollmodul 3 vorgeschaltet werden, an dem Netzleiter 4 für Energiezufuhr angeschlossen sind. Am Koppelelement 1 können Ergänzungskoppelelemente 5 einer ersten Art und Ergänzungskoppelelemente 6 einer zweiten Art zur Erweiterung der Anschlussplätze angeschlossen werden. Das Koppelelement 1 ist mit einer Anzahl von Festfunktionen für Anwendergeräte versehen. Es weist hierfür an seiner Anschlussseite 7 Anschlussplätze 8 für Einrichtungen mit Bedienoberfläche auf. Das Koppelelement 1 weist ferner Anschlussplätze 9 zum Anschließen von Modulen 10 mit Gattungsfunktionen für Anwendergeräte auf. Die Module 10 können auch Teil eines Anwendergerätes sein, an das weitere Geräteteile des Anwendergerätes anschließbar sind.

Am Koppelelement 1 ist im Ausführungsbeispiel nach FIG 1 eingangsseitig der Energiezuführung ein Anschlussplatz 11 für ein Kontrollmodul 3 ausgebildet. Das Kontrollmodul 3 kann einen Feinschutz für Anwendergeräte aufweisen. Es kann auch als Messplatz für Strom und bzw. oder Spannung ausgeführt sein. Die über Netzleiter 4 zugeführte Energie wird an den Anschlussplätzen 8 und 9 angeschlossenen Teilgeräten oder kompletten Anwendergeräten entsprechend überwacht zugeführt. Das Kontrollmodul 3 kann als Zentrale für Energiemanagement ausgebildet sein. Das Koppelelement 1 ist hinsichtlich seiner Anschlussplätze durch weitere ansetzbare Ergänzungskoppelelemente 5 und 6 erweiterbar. Die Ergänzungskoppelelemente 5 erster Art mit Festfunktion in einem Teilbereich und die Ergänzungskoppelelemente 6 zweiter Art ohne Festfunktionen können auf Basisfunktionen des Koppelelements 1 zurückgreifen. Sie brauchen dann selbst hierfür nicht ausgelegt zu sein. Durch über den Bus 2 empfangene Informationstelegramme lassen sich Funktionen in Anwendergeräten bzw. Teilgeräten oder Bedienoberflächen oder in Modulen für Anwendergeräte individuell definieren.

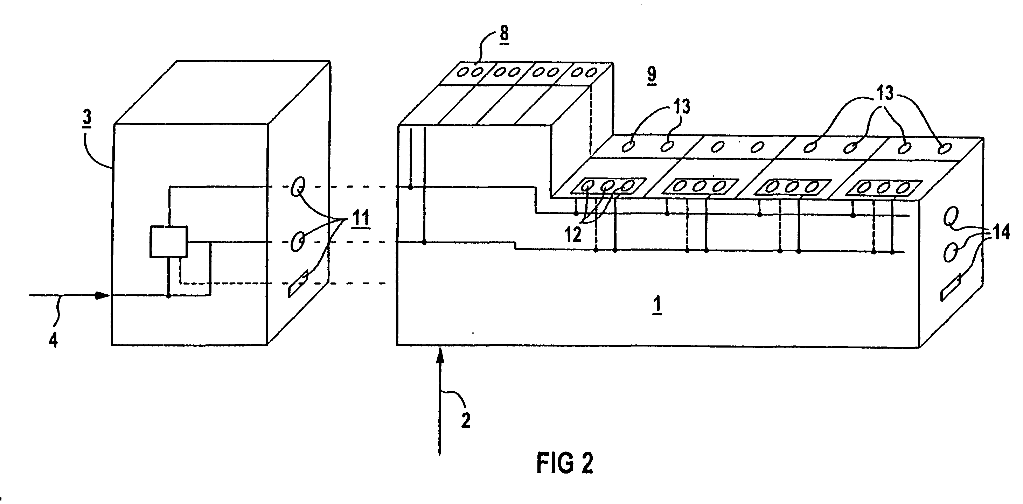

In FIG 2 ist ein Koppelelement 1 mit angeschlossenem Kontrollmodul 3 nach Art einer Explosionsdarstellung und in perspektivischer Wiedergabe veranschaulicht.

Die Anschlussplätze 8 und 9 des Koppelelements 1 sind im Ausführungsbeispiel als Steckplätze ausgeführt. Hierbei sind die Anschlussplätze 8 im Ausführungsbeispiel für Energieleitung und bei den Anschlussplätzen 9 Anschlüsse 12 für Energie und Anschlüsse 13 für Informationsübertragung ausgebildet. Nach Art des Anschlussplatzes 11 für ein Kontrollmodul ist im Ausführungsbeispiel am Koppelelement 1 ein Anschlussplatz 14 für Ergänzungskoppelelemente 5 erster Art und Ergänzungskoppelelemente 6 zweiter Art ausgebildet. Verständlicherweise kann am Anschlussplatz 14 ein Ergänzungskoppelelement 6 zweiter Art auch unmittelbar anschlossen sein und nicht in wie in FIG 1 mittelbar über ein Ergänzungskoppelelement 5 erster Art.

## Patentansprüche

1. Digitales Signalübertragungssystem der Gebäudesystemtechnik, mit einem eine Schnittstelle aufweisenden Koppelelement (1), welches
- mit einem Bus (2) verbindbar ist und an welchem Anwendergeräte anschließbar sind, wobei
- eine Anzahl von Anschlussplätzen (9) zum Anschließen von Modulen (10) mit Gattungsfunktionen für Anwendergeräte versehen ist und/oder zum Anschließen von Geräten mit Gattungsfunktionen ausgeführt ist, und
- als Energie- und Informationsversorgung für die Anwendergeräte bzw. Anwenderfunktionen dient,
**dadurch gekennzeichnet,**
**dass** das Koppelelement (1) eine Anzahl von Festfunktionen für anschließbare Anwendergeräte und zugeordnete Anschlussplätze (8) aufweist, wobei durch busseitige Informationstelegramme Funktionen in Anwendergeräten und/oder Modulen (10) für Anwendergeräte individuell definierbar sind und
**dass** das Koppelelement (1) eingangsseitig einen Anschlussplatz (11) mit Kontrollmodul (3) für die Energieeinleitung von einem externen Netzleiter (4) aufweist

2. Signalübertragungssystem nach Anspruch 1, **dadurch gekennzeichnet, dass** das Kontrollmodul (3) mit einer Sicherung in der Ausführung als Feinschutz für Anwendergeräte versehen ist.

3. Signalübertragungssystem nach Anspruch 1 oder 2, **dadurch gekennzeichnet, dass** das Kontrollmodul (3) als Messplatz für Strom und/oder Spannung ausgeführt ist.

4. Signalübertragungssystem nach Anspruch 3, **dadurch gekennzeichnet, dass** das Kontrollmodul (3) als Zentrale für Energiemanagement ausgebildet ist.

5. Signalübertragungssystem nach einem der Ansprüche 1 bis 4, **dadurch gekennzeichnet, dass** das Koppelelement (1) hinsichtlich seiner Anschlussplätze (8,9) mit zumindest einem Ergänzungskoppelelement (5,6) versehen ist, wobei dieses auf Basisfunktionen des Koppelelements (1) zurückgreift.

6. Signalübertragungssystem nach einem der Ansprüche 1 bis 5, **dadurch gekennzeichnet, dass** die Anschlussplätze (8,9) als Steckplätze (8,12,13) ausgeführt sind.

## Claims

1. Digital signal transmission system for building systems engineering, with a coupling element (1) having an interface, which coupling element (1)
- can be connected to a bus (2) and to which user appliances can be connected, whereby
- a number of connection slots (9) are provided for connecting modules (10) having generic functions for user appliances, and/or are designed for connecting appliances having generic functions, and
- act as a power and information supply for the user appliances or user functions,
**characterised in that**
the coupling element (1) has a number of permanent functions for connectable user appliances and associated connection slots (8), it being possible to use information messages on the bus to define functions in user appliances and/or modules (10) for user appliances on an individual basis, and
the coupling element (1) has a connection slot (11) on the input side with a control module (3) for supplying power from an external network conductor (4).

2. Signal transmission system according to Claim 1, **characterised in that** the supervisory module (3) is provided with a protective element in the form of a fine-protection element for user appliances.

3. Signal transmission system according to Claim 1 or 2; **characterised in that** the supervisory module (3) is in the form of a test rig for current and/or voltage.

4. Signal transmission system according to Claim 3, **characterised in that** the supervisory module (3) is in the form of a control centre for power management.

5. Signal transmission system according to one of Claims 1 to 4, **characterised in that** the connection slots (8, 9) of the coupling element (1) are provided with at least one complementary coupling element (5, 6), this complementary coupling element (5, 6) using basic functions of the coupling element (1).

6. Signal transmission system according to one of Claims 1 to 5, **characterised in that** the connection slots (8, 9) are in the form of plug-in slots (8, 12, 13).

## Revendications

1. Système numérique de transmission de signaux dans la technique des systèmes de bâtiments, ayant un élément de connexion (1) qui comporte une interface et
- qui peut être relié à un bus (2) et auquel des appareils utilisateurs peuvent être raccordés,
- un certain nombre d'emplacements de raccordement (9) étant munis de fonctions génériques pour appareils utilisateurs afin de raccorder des modules (10) et/ou étant réalisés avec des fonctions génériques afin de raccorder des appareils, et
- qui sert d'alimentation en énergie et en information pour les appareils utilisateurs ou pour les fonctions d'utilisateurs,
**caractérisé par le fait que**
l'élément de connexion (1) comporte un certain nombre de fonctions fixes pour des appareils utilisateurs raccordables et pour des emplacements de raccordement associés (8), des fonctions dans des appareils utilisateurs et/ou dans des modules (10) pour des appareils utilisateurs pouvant être définies individuellement par des télégrammes d'information du côté du bus, et
l'élément de connexion (1) comporte côté entrée un emplacement de raccordement (11) avec module de contrôle (3) pour l'introduction d'énergie depuis un conducteur de réseau (4) externe.

2. Système de transmission de signaux selon la revendication 1, **caractérisé par le fait que** le module de contrôle (3) est muni d'un fusible dans une réalisation comme fusible à fil fin pour des appareils utilisateurs.

3. Système de transmission de signaux selon la revendication 1 ou 2, **caractérisé par le fait que** le module de contrôle (3) est réalisé comme un emplacement de mesure pour un courant et/ou pour une tension.

4. Système de transmission de signaux selon la revendication 3, **caractérisé par le fait que** le module de contrôle (3) est conçu comme un central pour la gestion d'énergie.

5. Système de transmission de signaux selon l'une des revendications 1 à 4, **caractérisé par le fait que** l'élément de connexion (1) est muni, du point de vue de ses emplacements de raccordement (8, 9), d'au moins un élément de connexion auxiliaire (5, 6) qui accède à des fonctions de base de l'élément de connexion (1).

6. Système de transmission de signaux selon l'une des revendications 1 à 5, **caractérisé par le fait que** les emplacements de raccordement (8, 9) sont réalisés comme des emplacements à fiche (8, 12, 13).
